(19) **Europäisches Patentamt**

**European Patent Office**

**Office européen des brevets**

(11) **EP 0 974 196 B1**

(12) **EUROPÄISCHE PATENTSCHRIFT**

(45) Veröffentlichungstag und Bekanntmachung des Hinweises auf die Patenterteilung:
**10.05.2006 Patentblatt 2006/19**

(51) Int Cl.:
*H03L 7/099* (2006.01)     *H03L 1/02* (2006.01)
*H03L 7/18* (2006.01)

(21) Anmeldenummer: **98912232.0**

(22) Anmeldetag: **13.02.1998**

(86) Internationale Anmeldenummer:
**PCT/DE1998/000436**

(87) Internationale Veröffentlichungsnummer:
**WO 1998/045950 (15.10.1998 Gazette 1998/41)**

(54) **DIGITALE AFC-EINSTELLUNG DURCH REZIPROKE DDS**

AFC-DIGITAL TUNING THROUGH MUTUAL DIGITAL SYNTHESIS

REGLAGE NUMERIQUE C.A.F. PAR SYNTHESE NUMERIQUE RECIPROQUE

(84) Benannte Vertragsstaaten:
**DE ES FR GB IT**

(30) Priorität: **07.04.1997 DE 19714290**

(43) Veröffentlichungstag der Anmeldung:
**26.01.2000 Patentblatt 2000/04**

(73) Patentinhaber:
• **BenQ Mobile GmbH & Co. oHG**
  **81667 München (DE)**
• **BenQ Corporation**
  **Gueishan**
  **Taoyuan 333 (TW)**

(72) Erfinder: **HOFMANN, Ludwig**
  **D-85304 Ilmmünster (DE)**

(74) Vertreter: **Krombach, Rainer et al**
  **BenQ Mobile GmbH & Co. oHG**
  **Postfach 80 08 65**
  **81608 München (DE)**

(56) Entgegenhaltungen:
**EP-A- 0 595 013          EP-A- 0 599 609**
**DE-C- 4 320 087          GB-A- 2 132 042**
**US-A- 5 028 887          US-A- 5 216 389**

• **PATENT ABSTRACTS OF JAPAN vol. 015, no. 116 (P-1182), 20. März 1991 & JP 03 005966 A (MATSUSHITA ELECTRIC IND CO LTD), 11. Januar 1991**

EP 0 974 196 B1

## Beschreibung

Die vorliegende Erfindung bezieht sich auf eine Schaltung zur automatischen Frequenzkontrolle (AFC).

In vielen Geräten ist die Ausführung einer automatischen Frequenzkontrolle nötig. Das Anwendungsgebiet liegt dabei in der elektronischen Abstimmung der Frequenz von Oszillatorkreisen. Bei dieser elektronischen Abstimmung werden beispielsweise sogenannte Kapazitätsdioden verwendet. Kapazitätsdioden benötigen im Betrieb eine Gleichspannung von 10 Volt bis 30 Volt, die auf wenige Millivolt konstant sein muß. Für batteriegespeiste Empfänger sind sie deshalb nur zusammen mit einem Gleichspannungswandler zu verwenden. Ein großer Nachteil der Kapazitätsdioden ist die Temperaturabhängigkeit der Sperrschichtkapazität. Deshalb wird oft eine Diode mit gleichem Temperaturkoeffizienten als temperaturabhängiger Widerstand in die Zuführung der Speisespannung geschaltet.

Bei großen HF-Spannungen tritt durch die gekrümmte Kennlinie der Kapazitätsdiode eine Verschiebung des Gleichspannungsmittelwertes und damit eine Kapazitätsänderung auf. Dies kann zu Verzerrungen führen. Durch zwei gleiche, gegeneinander geschaltete Dioden kann man diese Kapazitätsänderungen kompensieren. Die Spannungsabhängigkeit und Temperaturabhängigkeit der Kapazitätsdioden wirkt sich vor allem bei hohen Frequenzen aus. Schon kleine Kapazitätsänderungen führen hier zu erheblichen Frequenzänderungen. Die Folge ist ein verzerrter Empfang des eingestellten Senders. Deshalb ist beispielsweise bei einer Diodenabstimmung eine automatische Frequenzregelung erforderlich. Die Regelgröße ist dabei die Frequenz des Oszillators. Mit der automatischen Frequenzregelung (AFC) wird somit durch Regelung der Oszillatorfrequenz die Abstimmung stabil gehalten.

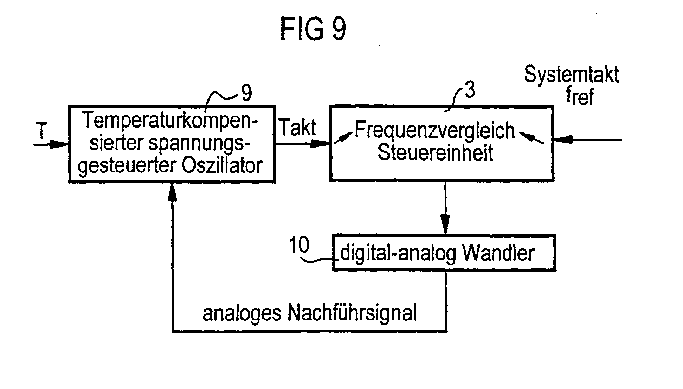

In Figur 9 ist eine bekannte AFC-Schaltung gezeigt. Ein temperaturkompensierter spannungsgesteuerter Oszillator (VCO) gibt dabei ein Signal mit einem bestimmten Takt zu einer Frequenz-Vergleichseinrichtung 3. Diese Frequenz-Vergleichseinrichtung 3 vergleicht den Takt des temperaturkompensierten spannungsgesteuerten Oszillators (VCO) 9 mit einem Systemtakt $f_{ref}$ , der z.B. aus einer Zeitnormalinformation gewonnen wird. Die Frequenz-Vergleichseinrichtung 3 gibt ein digitales Nachführsignal aus, das die in der Frequenz-Vergleichseinrichtung 3 ermittelte Frequenzdifferenz zwischen dem Takt des VCO 9 und dem Systemtakt $f_{ref}$ wiedergibt. Dieses digitale Nachführsignal wird einem Digital-Analog (D/A)-Wandler 10 zugeführt, der es in ein analoges Nachführsignal umsetzt. Dieses analoge Nachführsignal wird dem temperaturkompensierten VCO 9 zur Regelung seiner Oszillatorfrequenz zugeführt, wodurch die Regelschleife geschlossen ist.

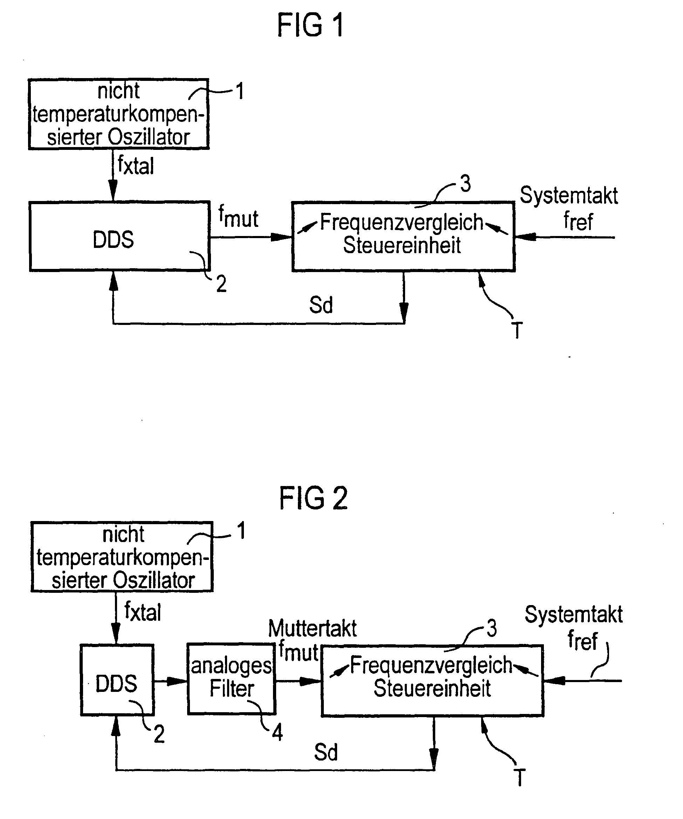

Wie aus Figur 9 ersichtlich ist also die Regelschleife analog realisiert. Diese analoge Realisierung hat indessen mehrere Nachteile zur Folge. Beispielsweise werden leicht Störungen eingekoppelt. Weiterhin stellen sich Probleme hinsichtlich des benötigten Dynamikbereichs. Dies spielt insbesondere eine große Rolle bei Geräten, in denen reduzierte Versorgungsspannungen vorliegen, wie es beispielsweise bei Mobiltelefonen der Fall ist. Als weiterer Nachteil ist anzuführen, daß der konstruktive Aufwand hinsichtlich des D/A-Wandlers 10 zum Nachführen der analogen Abstimmspannung sehr groß ist, da die Genauigkeit des Digital-Analog-Wandlers 10 für die Präzision der Regelung ausschlaggebend ist. Als weitere Nachteile sind noch zu nennen, daß die wie in Figur 1 gezeigt aufgebaute AFC-Schaltung langsam einschwingt und weiterhin aufgrund der analogen Nachführung schlecht in eine integrierte Schaltung integrierbar ist.

Ferner ist aus dem Dokument Patent Abstracts of Japan, Band 15, No. 116 (P1182), 20-03-1991 (Matsushita Electric Ind Co Ltd) und JP-A-3005966 (D1) eine Schaltung zur automatischen Frequenzregelung bekannt (siehe die Zusammenfassung und die Figuren 1,3,6 und 7 der entsprechenden japanischen Patentanmeldung), die in einfacher Weise eine genaue Nachführung der Oszillatorfrequenz ermöglicht.

In dieser Schaltung ist ein Oszillator vorgesehen, der mit einer Frequenz $f_{xtal}$ schwingt. Diese Frequenz $f_{xtal}$ des Oszillators wird einer direkten Digitalsynthese-Einrichtung als Takt zugeführt. Weiterhin ist ein Frequenz-Vergleichseinrichtung vorgesehen, die eine Differenz zwischen der Ausgangsfrequenz $f_{mut}$ der Digitalsynthese-Einrichtung und einer Referenzfrequenz $f_{ref}$ ermittelt. Die Frequenz-Vergleichseinrichtung erzeugt ein digitales Ausgangssignal, das die ermittelte Frequenzdifferenz zwischen der Ausgangsfrequenz $f_{mut}$ der Digitalsynthese-Einrichtung und der Referenzfrequenz $f_{ref}$ wiedergibt. Das digitale Ausgangssignal der Frequenz-Vergleichseinrichtung wird dann der Digitalsynthese-Einrichtung als Addierwert zugeführt, wodurch die Regelschleife geschlossen wird. Es liegt somit eine digitale Rückführung vor.

Die vorliegende Erfindung hat zur Aufgabe, eine verbesserte Schaltung zur automatischen Frequenzregelung anzugeben, die auch auf dem Prinzip der reziproken DDS basiert aber einen stabileren Betrieb aufweist.

Diese Aufgabe wird durch die Merkmale des Patentanspruchs 1 gelöst. Zentraler Gedanke der Erfindung ist es dabei, daß die Frequenzvergleichseinrichtung eine Tabelle aufweist, in der die Temperaturkennlinie des Oszillators abgespeichert ist, und daß der Frequenzvergleichseinrichtung zur Temperaturkompensation des Ausgangssignals eine Temperaturinformation zuführbar ist.

Zwischen der Digitalsynthese-Einrichtung und der Frequenz-Vergleichseinrichtung kann ein Bandpaßfilter mit einer Durchlaßfrequenz $f_{bp}$ geschaltet sein. Die Durchlaßfrequenz $f_{bp}$ entspricht dabei im wesentlichen dem zeitlichen Mittel der Frequenz $f_{mut}$ des Ausgangssignals der Digitalsynthese-Einrichtung. Durch das Vorsehen des Bandpaßfilters kann die spektrale Reinheit des Ausgangssignals der Digitalsynthese-Einrichtung verbessert werden.

Die Erfindung wird nun anhand eines Ausführungsbeispiels und bezugnehmend auf die Figuren der begleitenden Zeichnungen näher erläutert. Es zeigen:

Figur 1 eine erste erfindungsgemäße Schaltung zur automatischen Frequenzregelung (AFC) gemäß einem Ausführungsbeispiel der vorliegenden Erfindung,

Figur 2 eine weitere Schaltung zur automatischen Frequenzregelung gemäß dem Ausführungsbeispiel der vorliegenden Erfindung,

Figur 3 eine Schaltung zur automatischen Frequenzregelung, die nicht zu der vorliegenden Erfindung gehört,

Figur 4 eine weitere Schaltung zur automatischen Frequenzregelung, die auch nicht zu der vorliegenden Erfindung gehört,

Figur 5 eine Prinzipdarstellung einer Digitalsynthese-Einrichtung (DDS),

Figur 6 eine Darstellung zur Erläuterung des Betriebs einer Digitalsynthese-Einrichtung,

Figur 7 eine weitere Darstelllung zur Erläuterung der Frequenzumschaltung bei dem Betrieb einer Digitalsynthese-Einrichtung,

Figur 8 eine Darstellung zur Erläuterung der Umsetzung des von der Digitalsynthese-Einrichtung erzeugten Signals in ein sinusförmiges Signal, und

Figur 9 eine Schaltung zur automatischen Frequenzregelung gemäß dem Stand der Technik.

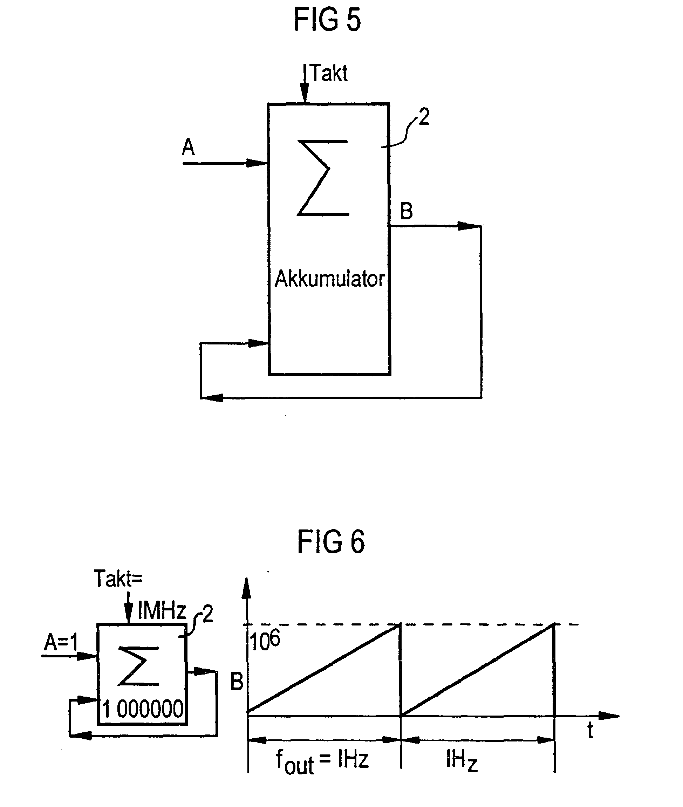

Zuerst soll eine sogenannte Digitalsynthese-Einrichtung (Direct Digital Synthesis, DDS) erläutert werden, die einen zentralen Baustein der vorliegenden Erfindung darstellt. Die Digitalsynthese-Einrichtung ermöglicht eine digitale Signalsynthese. In Figur 5 ist eine prinzipielle Darstellung der Funktion einer solchen Digitalsynthese-Einrichtung (DDS) 2 dargestellt. Die Grundfunktion einer DDS ist ein Akkumulator, der in einem bestimmten Takt ein Eingangssignal A auf das Ausgangssignal B aufaddiert. Die mathematische durch eine DDS ausgeführte Funktion läßt sich also wie folgt darstellen:

$$B_n = A + B_{(n-1)} \qquad \text{(Gleichung 1)}$$

Ist ein bestimmter Zahlenbereich, der sogenannte Akkumulatorbereich oder Addierbereich, überschritten, so fällt das Ausgangssignal der Digitalsynthese-Einrichtung (DDS) auf 0 bzw. den neu errechneten Wert B = B Modulo-Zählbereich zurück (Überlaufaddition). Zur Erläuterung soll folgendes Beispiel dienen:

Takt = 1 MHz

Addierwert A = 1

Akkumulatorbereich (Wortbreite, Addierbereich) = 1 Mio.

Gemäß der Funktion von Gleichung 1 läuft also der Ausgangswert B in diesem Fall kontinuierlich von 0 bis 1 Mio. hoch und fällt anschließend auf 0 zurück. Dann beginnt das Hochlaufen des Ausgangswerts B von Neuem. Daraus ergibt sich also, daß ein Sägezahn mit einer bestimmten Frequenz $f_{out}$ erzeugt wird. Diese Frequenz läßt sich wie folgt berechnen:

$$f_{out} = \frac{\underline{Takt \ x \ Addierwert \ A}}{Addierbereich} \qquad \text{(Gleichung 2)}$$

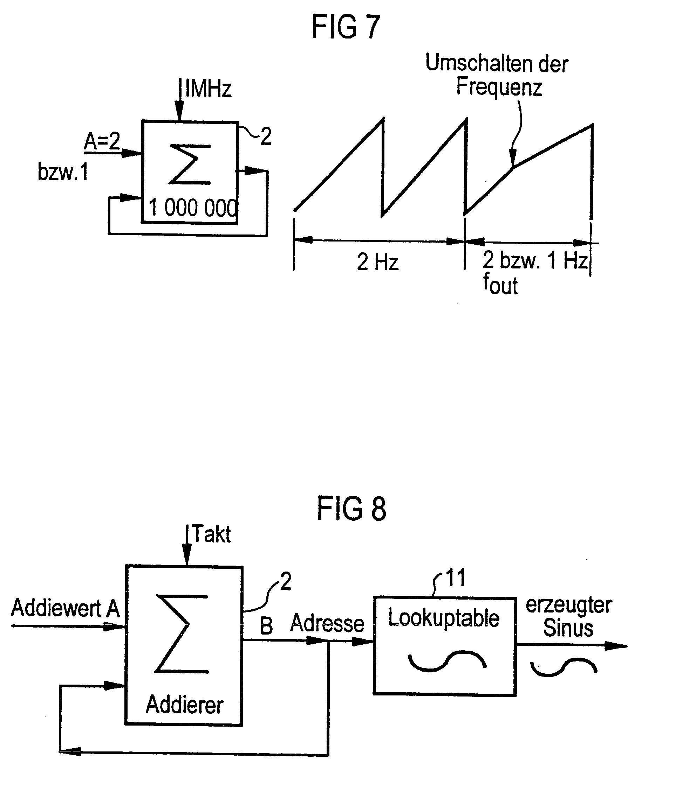

Wenn also der Takt 1 MHz ist, der Addierwert A = 1 beträgt und der Addierbereich = 1 Mio., wird in diesem Beispiel ein Sägezahn mit einer Wiederholungsfrequenz von 1 Hz erzeugt, wie es in Figur 6 dargestellt ist. Aus der Gleichung 2 ist einfach zu erkennen, daß die erzeugte Frequenz $f_{out}$ direkt vom Takt, dem anliegenden Addierwert A und der Wortbreite des Addierers (Akkumulators) abhängt. Nun soll der Fall betrachtet werden, daß der Addierwert A beispielsweise auf 2 geändert wird (siehe Figur 7). Wie sich aus der Gleichung 2 berechnen läßt, wird sich in diesem Fall die erzeugte Frequenz $f_{out}$ durch den Sprung des Addierwerts von 1 auf 2 von 1Hz auf 2Hz ändern. Es erfolgt also eine Umschaltung der erzeugten Frequenz $f_{out}$. Das Umschalten der Ausgangsfrequenz $f_{out}$ der DDS kann dabei sehr schnell, nämlich innerhalb eines Takts erfolgen. Weiterhin erfolgt das Umschalten der Frequenz $f_{out}$ ohne Phasensprung, wie ebenfalls aus Figur 7 ersichtlich ist.

Normalerweise wird zur Weiterverarbeitung kein sägezahnförmiges Signal erwünscht. Wie aus Figur 8 ersichtlich kann aus dem sägezahnförmigen Ausgangssignal mit der Frequenz $f_{out}$ der DDS 2 ein sinusförmiges Signal erhalten werden, in dem das Ausgangssignal B mit der Frequenz $f_{out}$ der DDS 2 als Adresse einer sogenannten Look-up-Tabelle 11 zugeführt wird. Die Umsetzung der Sägezahnfunktion erfolgt also über eine Look-up-Tabelle 11, so daß aus der Adreßinformation direkt ein Sinussignal erzeugt wird.

Wie insbesondere aus Gleichung 2 ersichtlich ist, läßt sich durch Änderung des Addierwerts A eine FM-Modulation des erzeugten Signals mit der Frequenz $f_{out}$ ermöglichen. Die maximal erzeugbare Frequenz $f_{out}$ des Ausgangssignals der DDS 2 ist theoretisch die halbe Taktfrequenz der DDS 2. In der Praxis sollte indessen die maximale Frequenz bei maximal 30% der Taktfrequenz der DDS 2 liegen. Falls die DDS für eine Anwendung im Mobilfunkbereich dienen soll, kann sie als integrierte Schaltung (IC) beispielsweise in einer CMOS-Technik hergestellt werden.

Nach der prinzipiellen Erläuterung der Funktion einer Digitalsynthese-Einrichtung (DDS) soll nun ein Ausführungsbeispiel einer erfindungsgemäßen Schaltung zur automatischen Frequenzregelung erläutert werden. Wie aus Figur 1 ersichtlich wird das Ausgangssignal eines nicht temperaturkompensierten Oszillators 1 mit der Frequenz $f_{xtal}$ als Takt einer Digitalsynthese-Einrichtung (DDS) 2 zugeführt. Die DDS 2 erzeugt ein Ausgangssignal mit der Frequenz $f_{mut}$, das als Muttertakt einer Frequenzvergleichs-einrichtung 3 zugeführt wird. Die Frequenzvergleichseinrichtung 3 vergleicht die Frequenz $f_{mut}$ des Ausgangssignals der DDS 2 mit einer Referenzfrequenz $f_{ref}$, die beispielsweise in Form eines Systemtakts aus einer Zeitnormalinformation gewonnen werden kann. Die Referenzfrequenz $f_{ref}$ kann aber auch durch einen Referenzoszillator wie beispielsweise einem Quartz gewonnen werden. Die Frequenzvergleichseinrichtung 3 erzeugt ein digitales Ausgangssignal, das von der ermittelten Differenz zwischen der Frequenz $f_{mut}$ des Ausgangssignals der DDS 2 und der Referenzfrequenz $f_{ref}$ abhängt. Die Frequenzvergleichseinrichtung 3 wird normalerweise softwaremäßig ausgeführt sein. Das digitale Ausgangssignal $S_d$ der Frequenzvergleichseinrichtung 3 wird als Addierwert der DDS 2 zugeführt.

In der Frequenzvergleichseinrichtung 3 ist eine Tabelle abgespeichert, die die Kennlinie der Temperaturabhängigkeit f(T) der Frequenz des nicht temperaturkom pensierten Oszillators 1 wiedergibt. Wenn nun der Frequenzvergleichseinrichtung 3 eine Temperaturinformation T zugeführt wird, kann diese das digitale Ausgangssignal $S_d$ temperaturkompensieren, in dem sie aus der Temperaturinformation T und der abgespeicherten Kennlinie der Temperaturabhängigkeit des nicht temperaturkompensierten Oszillators 1 ermittelt, in wieweit das digitale Ausgangssignal $S_d$ erhöht bzw. erniedrigt werden muß, um die Temperaturabhängigkeit (Drift) des Oszillators 1 zu kompensieren. Aus einem Taktsignal, nämlich dem Ausgangsignal des nicht temperaturkompensierten Oszillators 1 mit der Frequenz $f_{xtal}$, die weder temperaturkompensiert noch sonst nachgeführt wird, wird somit mit Hilfe der DDS 2 und der als Steuereinheit wirkenden Frequenzvergleichseinrichtung 3 ein temperaturkompensiertes und auf einen Systemtakt mit der Frequenz $f_{ref}$ nachgeführtes Signal $f_{mut}$ erzeugt.

Indessen ist zu berücksichtigen, daß das Ausgangssignal der DDS 2 mit der Frequenz $f_{mut}$, das als Muttertakt verwendet wird, hinsichtlich seiner spektralen Reinheit in der Regel wesentlich schlechter ist als ein Quarz. Dies ergibt sich aus der Tatsache, daß die spektrale Reinheit durch die Auflösung der D/A-Wandler in der DDS 2 bestimmt wird und diese D/A-Wandler nicht beliebig gut sein können. In Figur 2 ist dargestellt, wie sich dieser Nachteil beseitigen läßt. Wie aus Figur 2 ersichtlich kann zwischen der DDS 2 und der Frequenzvergleichseinrichtung 3 ein analoges Filter 4 geschaltet werden, das insbesondere das Weitabspektrum des Ausgangssignals der DDS 3 mit der Frequenz $f_{mut}$ verbessert. Die Verbesserung des Nahspektrums ist naturgemäß geringer. Bei dem analogen Filter 4 handelt es sich um ein Bandpaßfilter mit einer Durchlaßfrequenz $f_{bp}$, die so gewählt ist, daß sie im wesentlichen dem zeitlichen Mittel der Frequenz $f_{mut}$ des Ausgangssignals der DDS 2 entspricht.

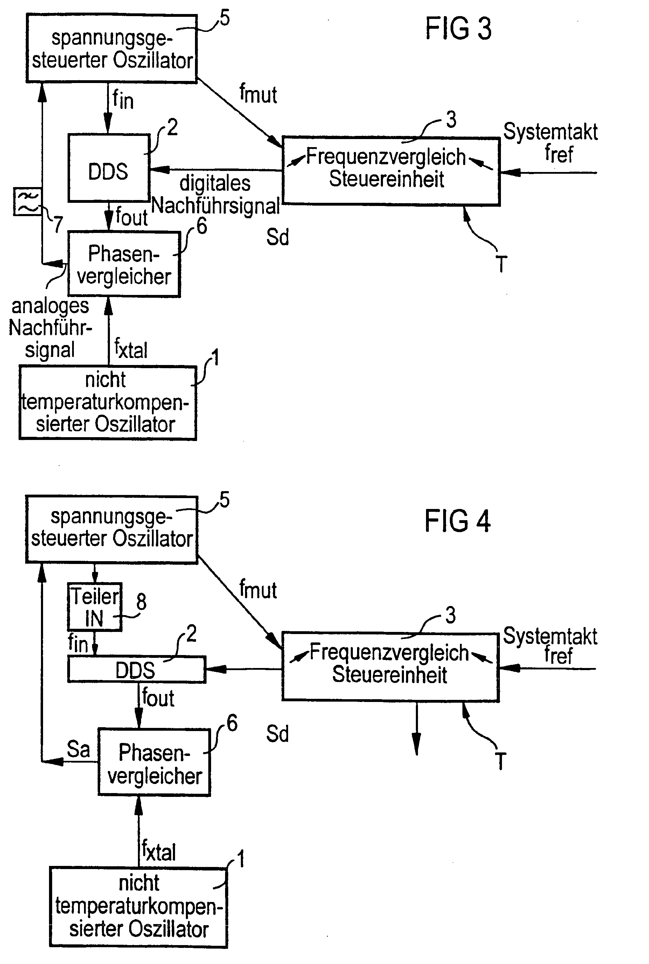

Nun wird eine Schaltung zur automatischen Frequenzregelung dargestellt, die in Figur 3 dargestellt ist. Wie aus Figur 3 ersichtlich wird das Ausgangssignal des nicht temperaturkompensierten Oszillators 1 mit der Frequenz $f_{xtal}$ einem sogenannten Phasenvergleicher (Phasenkomperator) 6 zugeführt. Der Phasenvergleicher 6 vergleicht die Phase des Ausgangssignals des nicht temperaturkompensierten Oszillators 1 mit der Frequenz $f_{xtal}$ mit der Phase des Ausgangssignals einer DDS 2 mit der Frequenz $f_{out}$. Der Phasenvergleicher 6 erzeugt ein analoges Ausgangssignal (Nachführsignal) abhängig von dem Ergebnis des Vergleichs der Phase des Ausgangssignals des nicht temperaturkompensierten Oszillators 1 bzw. der DDS 2. Dieses analoge Nachführsignal wird mittels eines Tiefpaßfilters 7 einem spannungsgesteuerten Oszillator 5 zugeführt. Der VCO 5 kann beispielsweise durch mit Kapazitätsdioden abstimmbaren Oszillatoren, astabilen Kippschaltungen und Sperrschwingern aufgebaut sein. Das Ausgangssignal des spannungsgesteuerten Oszillators 5 mit der Frequenz $f_{in}$ wird der Digitalsyntheseeinrichtung 2 als Takt zugeführt. Das Ausgangssignal des spannungsgesteuerten Oszillators 5 wird darüber hinaus als Muttertakt mit der Frequenz $f_{mut}$ einer Frequenzvergleichseinrichtung 3 zugeführt. Diese Frequenzvergleichseinrichtung 3 vergleicht die Frequenz $f_{mut}$ des spannungsgesteuerten Oszillators 5 mit einer Referenzfrequenz $f_{ref}$ die beispielsweise als Systemtakt aus einer Zeitnormalinformation gewonnen werden kann. Die Frequenzvergleichseinrichtung 3 kann, weiterhin Vorrichtungen zur Temperaturkompensation aufweisen, wobei eine Information über die Temperatur T zugeführt wird. Die Frequenzvergleichseinrichtung 3 erzeugt abhängig vom Ergebnis des Frequenzvergleichs ein digitales Nachführsignal SD. Dieses digitale Nachführsignal SD wird der DDS 2 als Addierwert zugeführt.

Der spannungsgesteuerte Oszillator wird also in Art einer PLL (Phase Locked Loop) auf die Muttertaktfrequenz $f_{mut}$ in der Weise nachgeführt, daß das Ausgangssignal der DDS 2 mit der Frequenz $f_{out}$ mit der Frequenz $f_{xtal}$ eines nicht temperaturkompensierten Oszillators verglichen wird. Die Nachführung dieser PLL-artigen Schaltung erfolgt durch Einstellen des Steuerwerts der DDS 2. Dieser Steuerwert kann dabei sehr fein abstufbar (nicht ganzzahlig) sein. Dabei gelten die folgenden Gleichungen

$$\text{Gleichung 3} \qquad \underline{\frac{Fout}{Fin}} = \underline{\frac{Addierwert}{Addierbereich}}$$

$$\text{Gleichung 4} \qquad Fout = \underline{\frac{Fin * Addierwert}{Addierbereich}}$$

der DDS 2.

Dabei ist zu berücksichtigen, daß die Frequenz $f_{xtal}$ des nicht temperaturkompensierten Oszillators 1 und auch die Frequenz des Ausgangssignals der DDS 2 im Vergleich zu der Frequenz $f_{in}$ des spannungsgesteuerten Oszillators 5 sehr klein ist, wie sich aus Gleichung 2 ergibt, wobei zu berücksichtigen ist, daß der Wert des Addierbereichs wesentlich größer ist als der des Addierwerts A.

Im phasen- und frequenzstarren Ankopplungszustand der in Figur 3 gezeigten Schaltung ist $f_{out} = f_{xtal}$ und in diesem geregelten Zustand gilt:

$$\text{Gleichung 5} \qquad \underline{\frac{Fin}{Fxtal}} = \underline{\frac{Addierbereich}{Addierwert}}$$

Aus dieser Gleichung ist zu erkennen, daß die erzeugte Mutterfrequenz $f_{mut}$ sehr fein abstufbar in kleinen Schritten durch Änderung des Addierwerts an den nicht temperaturkompensierten Oszillator 1 angebunden werden kann. Somit kann das Ausregeln der Temperaturdrift des nicht temperaturkompensierten Oszillators 1 und der Frequenzablage durch die Steuerung durch stetiges Nachführen dieses Addierwerts als Steuerwert erfolgen. Die Unterdrückung von unerwünschten Signalen erfolgt durch den Oszillator 1 selbst, da dieser eine hohe Güte aufweist, sowie durch das Tiefpaßfilter 7.

In Figur 4 ist eine Modifikation der in Figur 3 gezeigten Schaltung zur automatischen Frequenzregelung dargestellt. Diese Modifikation ist vorteilhaft, falls ein Muttertakt $f_{mut}$ mit sehr hoher Frequenz erzeugt werden soll. Wie aus Figur 4 ersichtlich wird dazu ein Frequenzteiler (Vorteiler) 8 zwischen den spannungsgesteuerten Oszillator 5 und die Digital-Syntheseeinrichtung 2 geschaltet. Dieser Teiler 8 teilt die Frequenz des Ausgangssignals des spannungsgesteuerten Oszillators 5 um einen vorbestimmten Wert N. Diese um den Wert N herabgeteilte Frequenz $f_{in}$ wird dann der DDS 2 als Takt zugeführt. Die DDS 2 kann somit mit niedrigem Takt im Vergleich zu dem Muttertakt $f_{mut}$ laufen, wodurch der Stromverbrauch und die Anforderungen an die DDS gesenkt werden können. Dies ist besonders vorteilhaft bei Anwendungen wie beispielsweise bei Mobilfunkgeräten, bei denen ein geringer Stromverbrauch höchste Priorität hat.

Durch die digitale Nachführung und die Verwendung der DDS 2 kann somit ein Signal erzeugt werden, das sehr genau und temperaturkompensiert ist.

**Patentansprüche**

1. Schaltung zur automatischen Frequenzregelung, aufweisend:

   - einen Oszillator (1), der mit einer Frequenz $f_{xtal}$ schwingt,
   - eine Digitalsynthese-Einrichtung (2), der die Frequenz $f_{xtal}$ des Oszillators (1) als Takt zugeführt wird und die ein Ausgangssignal mit der Frequenz $f_{mut}$ erzeugt, und
   - eine Frequenz-Vergleichseinrichtung (3), die eine Differenz zwischen der Ausgangsfrequenz $f_{mut}$ der Digitalsynthese-Einrichtung (2) und einer Referenzfrequenz $f_{ref}$ ermittelt und ein die ermittelte Frequenzdifferenz wiedergebendes digitales Ausgangssignal (Sd) erzeugt,

   wobei das digitale Ausgangssignal (Sd) der Digitalsynthese-Einheit (2) als Addierwert zugeführt wird,
   **dadurch gekennzeichnet, daß**
   die Frequenz-Vergleichseinrichtung (3) eine Tabelle aufweist, in der die Temperatur-Kennlinie des Oszillators abgspeichert ist, und daß der Frequenz-Vergleichseinrichtung (3) zur Temperaturkompensation des Ausgangssignals (Sd) eine Temperaturinformation zuführbar ist.

2. Schaltung nach Anspruch 1,
   **dadurch gekennzeichnet,**
   **daß** zwischen der Ditigalsynthese-Einrichtung (2) und der Frequenz-Vergleichseinrichtung (3) ein analoges Bandpaßfilter (4) mit einer Durchlaßfrequenz $f_{bp}$ geschaltet ist, die im wesentlichen dem zeitlichen Mittel der Frequenz $f_{mut}$ des Ausgangssignals der Digitalsynthese-Einrichtung (2) entspricht.

**Claims**

1. Circuit for automatic frequency control exhibiting the following:

   - an oscillator (1) which oscillates at a frequency $f_{xtal}$,
   - a digital synthesis device (2) to which the frequency $f_{xtal}$ of the oscillator (1) is supplied as clock frequency and which generates an output signal having the frequency $f_{mut}$, and
   - a frequency comparison device (3) which determines a difference between the output frequency $f_{mut}$ of the digital synthesis device (2) and a reference frequency $f_{ref}$ and generates a digital output signal (Sd) reproducing the frequency difference determined,

   the digital output signal (Sd) being supplied as addition value to the digital synthesis unit (2), **characterized in that** the frequency comparison device (3) exhibits a table in which the temperature characteristic of the oscillator is stored, and **in that** a temperature information can be supplied to the frequency comparison device (3) for temperature compensation of the output signal (Sd).

2. Circuit according to Claim 1, **characterized in that** an analogue band-pass filter (4) having a pass frequency $f_{bp}$, which essentially corresponds to the time average of the frequency $f_{mut}$ of the output signal of the digital synthesis device (2), is connected between the digital synthesis device (2) and the frequency comparison device (3).

**Revendications**

1. Circuit de régulation automatique de fréquence, comprenant :

   - un oscillateur (1) qui oscille avec une fréquence $f_{xtal}$,
   - un dispositif de synthèse numérique (2) auquel est amenée la fréquence $f_{xtal}$ de l'oscillateur (1) comme cadence et qui produit un signal de sortie avec la fréquence $f_{mut}$, et
   - un dispositif de comparaison de fréquence (3) qui détecte une différence entre la fréquence de sortie $f_{mut}$ du dispositif de synthèse numérique (2) et une fréquence de référence $f_{ref}$ et produit un signal de sortie numérique (Sd) reproduisant la différence de fréquence détectée,

   ledit signal de sortie numérique (Sd) étant amené au dispositif de synthèse numérique (2) comme valeur d'addition,
   **caractérisé en ce que**

le dispositif de comparaison de fréquence (3) comporte une table dans laquelle est enregistrée la caractéristique de température de l'oscillateur et qu'une information de température peut être amenée au dispositif de comparaison de fréquence (3) pour la compensation de température du signal de sortie (Sd).

2. Circuit selon la revendication 1,
   **caractérisé en ce que**
   entre le dispositif de synthèse numérique (2) et le dispositif de comparaison de fréquence (3) est monté un filtre passe-bande analogique (4) avec une fréquence passante $f_{bp}$ qui correspond essentiellement à la moyenne temporelle de la fréquence $f_{mut}$ du signal de sortie du dispositif de synthèse numérique (2).

## FIG 1

## FIG 2

FIG 3

FIG 4

# FIG 5

# FIG 6

## FIG 7

IMHz

A=2
bzw.1

$\sum$

~2

1 000 000

Umschalten der
Frequenz

2 Hz

2 bzw. 1 Hz
$f_{out}$

## FIG 8

Takt

Addiewert A

$\sum$

~2

Addierer

B  Adresse

11

Lookuptable

erzeugter
Sinus

## FIG 9

Temperaturkompensierter spannungsgesteuerter Oszillator  ~9

Takt →

Frequenzvergleich
Steuereinheit  ⌐3

Systemtakt
fref

10 ⌐ digital-analog Wandler

analoges Nachführsignal